# EUROPEAN PATENT SPECIFICATION

(11) **EP 2 757 688 B1**
(45) Date of publication and mention of the grant of the patent: **22.05.2019**
(21) Application number: 13151860.7
(22) Date of filing: 18.01.2013
(51) Int. Cl.: H03K 17/14

(54) **Active clamped transistor circuit for low temperature operating conditions**
Aktive geklemmte Transistorschaltung für Niedertemperaturbetriebsbedingungen
Circuit de transistor avec calage actif pour des conditions de fonctionnement à basse température

(43) Date of publication of application: 23.07.2014
(73) Proprietor: HS Elektronik Systeme GmbH, 86720 Nördlingen (DE)
(72) Inventor: Greither, Markus, 86154 Augsburg (DE)
(74) Representative: Schmitt-Nilson Schraud Waibel Wohlfrom Patentanwälte Partnerschaft mbB

(56) References cited:
- EP-A1- 0 622 849
- EP-A1- 1 921 531
- DE-A1- 4 122 347
- DE-A1- 10 014 641
- DE-A1- 10 137 764
- DE-A1-102006 047 243
- US-A1- 2010 237 356
- US-A1- 2012 051 106
- US-B1- 6 385 028
- US-B1- 6 614 633
- BABA K ET AL: "STATCOM Applying Flat-Packaged IGBTs Connected in Series", IEEE TRANSACTIONS ON POWER ELECTRONICS, IEEE SERVICE CENTER, PISCATAWAY, NJ, US, vol. 20, no. 5, 1 September 2005 (2005-09-01), pages 1125-1132, XP011138686, ISSN: 0885-8993, DOI: 10.1109/TPEL.2005.854054
- PIAZZESI A ET AL: "Series connection of 3.3kV IGBTs with active voltage balancing", POWER ELECTRONICS SPECIALISTS CONFERENCE, 2004. PESC 04. 2004 IEEE 35TH ANNUAL, AACHEN, GERMANY 20-25 JUNE 2004, PISCATAWAY, NJ, USA,IEEE, US, 20 June 2004 (2004-06-20), pages 893-898, XP010739778, DOI: 10.1109/PESC.2004.1355537 ISBN: 978-0-7803-8399-9

## Description

The present disclosure is directed to transistor controls for overvoltage protection in general, and more particularly to an improved active clamp circuit for use with a transistor, in particular under low temperature operating conditions.

Modern vehicle power control systems typically use switching transistors, such as metal oxide semiconductor field effect transistors (MOSFETs), to control power distribution throughout the vehicle. In such a configuration, the transistors are protected from periodic or incidental occurrence of overvoltage conditions, which may be caused e.g. by switching inductive loads, using clamping circuits that prevent the voltage across the transistor from exceeding a clamp value. Clamp circuits can be either active clamp circuits, that affect the circuit only when the predefined clamp voltage is exceeded, or passive clamp circuits that have an ongoing effect on the circuit.

Active clamp circuits for e.g. MOSFET transistors shunt power from a transistor drain to the transistor gate when a drain to source voltage of the transistor exceeds a threshold voltage. When power is shunted to the transistor gate, the transistor is turned on, thereby allowing power to flow across the transistor and preventing excessive drain to source voltages.

A typical active clamp circuit includes either a unidirectional Zener diode or a unidirectional TVS diode in series with a forward blocking rectifier diode. The Zener diode or TVS diode and the forward blocking rectifier diode are connected between the gate and drain of the transistor. In such a configuration, the Zener or TVS diode allows current to pass when the voltage exceeds the breakdown voltage of the Zener or TVS diode, and the forward blocking diode prevents reverse current flow when the transistor is turned on.

Fig. 1a corresponds to Fig. 1 in DE 101 37 764 A1 and shows an active clamping circuit 10 as overvoltage protection for the MOSFET 110, corresponding to the preamble of claims 1, 3, 4, 13, 14, and 15. A unidirectional TVS diode D1-1 basically having voltage-current characteristics similar to that of a Zener diode is connected between a Drain node 112 and a gate node 116 of the MOSFET 110. In case of overvoltage at the drain node 112 of the MOSFET 110, the gate node 116 of the MOSFET 110 is controlled to keep the path between a source node 114 and the drain node 112 (source-to-drain path) in a conducting state as long as the overvoltage is present at the drain node 112. Further, there is a conventional rectifier diode D2-1 connected in series to the TVS diode D1-1 which is oriented in a blocking direction with regard to a short connection of a positive control input at the gate control input 140 via the drain-to-source path of the MOSFET 110.

Fig. 1b corresponds to Fig. 4 in DE 41 22 347 A1 and shows basically a similar active clamping circuit in which in comparison to Fig. 1a instead of the rectifier diode D2-1 (Fig. 1a) a correspondingly connected Zener diode D2-2 and instead of the TVS diode D1-1 (Fig. 1a) a correspondingly connected Zener diode D1-2 is used.

Baba K. et al, "STATCOM Applying Flat-Packed IGBTs Connected in Series", IEEE Transactions on Power Electronics, vol. 20, no. 5 (2005), pages 1125 - 1132 and EP 1 921 531 A1 show solid state power controllers including bidirectional active voltage clamp circuits including anti serially connected zener diodes.

US 6 614 633 B1 shows a protecting apparatus for protecting a main transistor in which a protecting capacitor or Zener diode circuit is connected between a control terminal of a protecting transistor and an input terminal of the main transistor for allowing initial surge current, when caused based on a rapid surge, to flow into the control terminal of said protecting transistor.

US 2010/0237356 A1 discloses silicon carbide devices for transient voltage suppression.

EP 0 622 849 A1 discloses an active clamped transistor circuit with a feedback path comprising serially connected zener diodes in reverse bias and a rectifier diode in forward bias between the output node and the control node.

DE 10 2006 047243 A1 discloses an active clamped transistor circuit with a feedback path comprising a serially connected zener diode in reverse bias and a rectifier diode in forward bias between the output node and the control node where the temperature coefficient of the active clamp feedback path is similar to the temperature coefficient of the transistor.

A typical field of application of such active clamped transistors is solid state power controllers (SSPC). SSPCs are semiconductor devices that control power (voltage and/or current) supplied to a load. There are several basic types of SSPC. AC controllers are designed to switch alternating current (AC) voltages, DC controllers are designed to switch direct current (DC) voltages, and AC/DC controllers are designed to switch both AC and DC voltages.

It has been unexpectedly experienced during production acceptance tests at low temperatures, e.g. below -40 degrees Celsius, that some channels of an AC solid state SSPC failed on an instantaneous trip test; the failure lead to a blown fuse link and at least one defect MOSFET.

Thus, it may be desirable to have available an improved active clamped transistor circuit that is particularly reliable in low temperature conditions.

### SUMMARY

According to one aspect of the invention, an active clamped transistor circuit comprises a transistor having a control node to control the conduction state of a controlled current path between a first output node and a second output node. In case of a voltage between the first and the second output nodes exceeding a threshold voltage, the transistor is turned on by means of a feedback path coupling the first output node to the control node such that current is allowed to flow across the controlled current path of the transistor to prevent excessive voltages between the first and the second output nodes. The feedback path comprises a serial connection of: (i) at least one Zener diode and/or at least one unidirectional transient voltage suppressor diode, connected in blocking direction, and (ii) at least one rectifier diode connected in flow direction, all directions with respect to the direction of current from the first output node to the control node. A capacitor is connected parallel to the rectifier diode.

According to a further aspect of the invention, an active clamped transistor circuit comprises a transistor having a control node to control the conduction state of a controlled current path between a first output node and a second output node. In case of a voltage between the first and the second output nodes exceeding a threshold voltage, the transistor is turned on by means of a feedback path coupling the first output node to the control node such that current is allowed to flow across the controlled current path of the transistor to prevent excessive voltages between the first and the second output nodes. The feedback path comprises a serial connection of: (i) at least one Zener diode and/or at least one unidirectional transient voltage suppressor (TVS) diode, connected in blocking direction, and (ii) at least one Schottky diode (SD) connected in flow direction, all directions with respect to the direction of current from the first output node to the control node.

According to a further aspect of the invention, a method for improving an active clamped transistor circuit is provided in accordance with the appended claims.

### BRIEF DESCRIPTION OF THE DRAWINGS

Fig. 1a and 1b illustrate active clamping circuits known form prior art;
Fig. 2 illustrates a first embodiment of an improved active clamped transistor circuit;
Fig. 3 illustrates a second embodiment of an improved active clamped transistor circuit;
Fig. 4a illustrates an example of an active clamped transistor circuit;
Fig. 4b illustrates another active clamped transistor circuit; and
Fig. 5 illustrates an example application of an improved active clamped transistor in a power distribution system of an aircraft.

### DETAILED DESCRIPTION

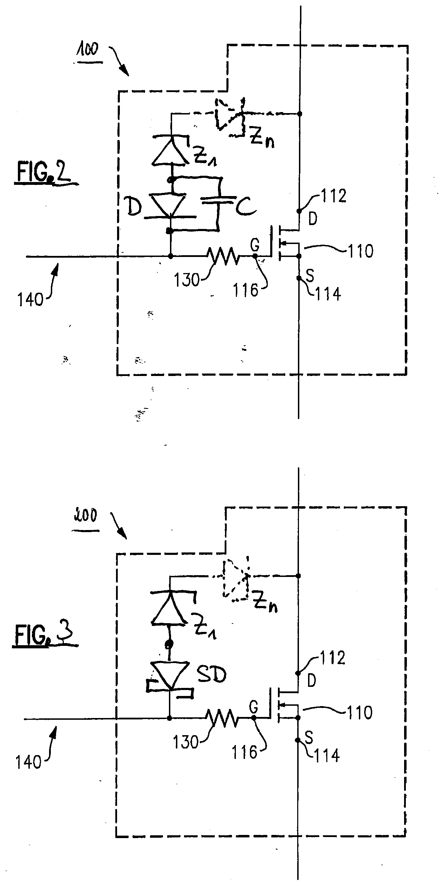

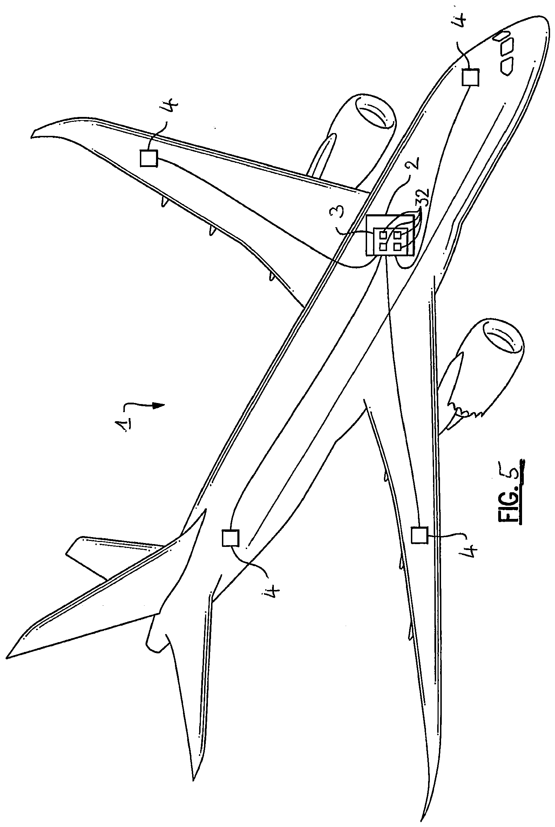

Figs.2 and 3 illustrate several embodiments of an improved active clamped transistor circuit 100 and 200 including a transistor 110, which is by way of example throughout all embodiments implemented by a MOSFET. The active clamped transistor circuits 100, 200, 300, 310 in Figs. 2 to 4b include identical elements, where like numerals indicate like elements. Each active clamped transistor circuit is arranged to operate as a power switch, usable for instance in a power switch circuit 32 depicted in Fig. 5. The transistor 110 has a drain node 112, a source node 114 and a gate node 116. A control signal input 140 passes through a conditioning resistor 130 and controls the operational state of the transistor 110.

In all embodiments of Figs. 2 to 3 a conditioning resistor 130 may be used to ensure that the control signal received by the transistor 110 is suitable to control the transistor 110. For instance, the gate of a MOSFET comprises an inherent capacity. When supplying a control signal to the gate of the MOSFET as a control node, this gate capacity needs to be charged or discharged, respectively. In order to limit the electrical current that occurs during this charging and discharging, the conditioning resistor 130 can be dimensioned accordingly. Another use of the resistor is to avoid parasitic oscillations during the active clamp operation, which can damage the component.

When a signal is present on the control signal input 140 the transistor 110 is on and allows flow of electrical current from drain to source. When no signal is present on the control signal input 140, the transistor 110 is off and prohibits flow of electrical current from drain to source. The control signal input 140 for instance may originate from a controller 3 (as illustrated in Figure 5).

Electronic semiconductor components blocking current flow, such as diodes and transistors, include a maximum voltage rating under which the component can continue to block current flow. When the voltage rating is exceeded, the electrical component breaks down and begins to allow current flow. The maximum voltage rating is referred to as an avalanche breakdown potential, and when the avalanche breakdown potential is exceeded, the electrical component is said to be in the avalanche breakdown state.

Some semiconductor components, such as zener diodes or transient voltage suppressor (TVS) diodes, are designed to be operated within the avalanche breakdown state and can transition between normal mode operation and avalanche breakdown operation with no damage to the component. Other electrical components, such as metal oxide semiconductor field effect transistors (MOSFETs) can be damaged or destroyed if they enter the avalanche breakdown state.

In a first place, a TVS diode basically is an electronic component especially configured for protection of sensitive electronics from voltage spikes induced on connected wires. Usually, the TVS diode is connected in a blocking direction and presents, under normal operating conditions, a high impedance (appears as an open circuit) to the component to be protected. When the voltage applied to the TVS diode increases above the avalanche breakdown potential of the TVS diode, the TVS diode avalanches to provide a low impedance path for the transient current. As a result, the transient current is diverted away from the component to be protected, and is shunted through the TVS diode. The TVS diode returns to a high impedance state after the transient threat passed. Thus, a TVS diode is a clamping device that is operated in blocking direction and is dedicated to suppress overvoltage above its breakdown voltage.

There exist unidirectional TVS diodes and bidirectional TVS diodes. A unidirectional TVS diode in principle may operate as a rectifier diode when connected in the flow direction, like any other rectifier diode does. However, unidirectional TVS diodes typically are operated as avalanche diodes and thus connected in blocking direction, as described above. In such configuration, unidirectional TVS diodes are particularly made and tested to handle very large peak currents, e.g. there are TVS diodes able to absorb up to 1500 W of peak power, for a short time. A bidirectional TVS diode can be represented by two mutually opposing unidirectional TVS diodes connected in series to one another and connected in parallel to the circuit to be protected. While this representation is schematically accurate, physically bidirectional TVS diodes are manufactured as a single component. Bidirectional TVS diodes are used in situations where an avalanche diode is required with respect to opposite directions of electric current, e.g. in case a component needs to be protected against AC spikes.

In the first embodiment of the active clamped circuit, shown in Figure 2, the feedback path comprises a serial connection of the conventional rectifier diode D and one or more Zener diodes Z1, ..., Zn. The rectifier diode D is connected in flow direction with respect to current from the drain node 112 to the gate node 116, to block current flow from the input terminal 140 to the drain node 112 of the transistor 110. The at least one Zener diode Z1 is connected in blocking direction with respect to current from the drain node 112 to the gate node 116, and thus is operated as an avalanche diode. Thus, the feedback path connects the gate node 116 of the transistor via the conditioning resistor 130 to the drain node 112 of the transistor 110. A capacitor C is connected in parallel to the rectifier diode D. The capacitor C has a capacitance of 28pF or more, e.g. 68pF.

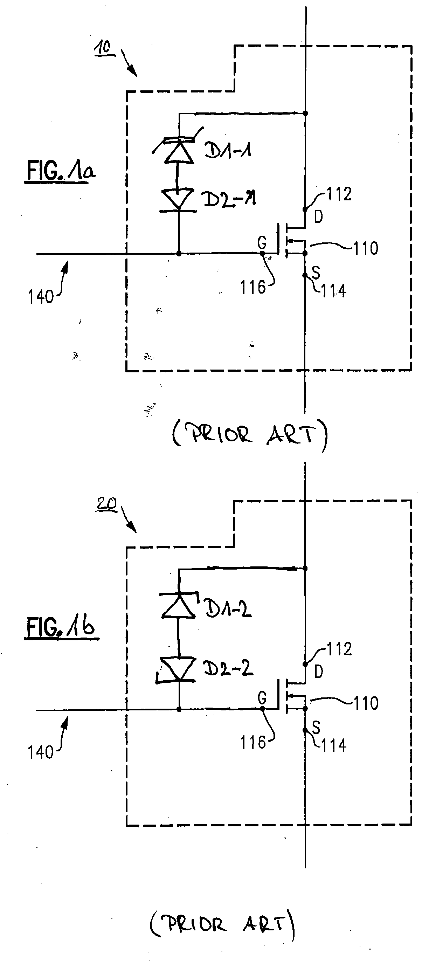

The inventor found out that conventional active clamped circuits as shown in Figures 1a or 1b do not operate reliably under low temperature conditions down to - 40 degrees Celsius, or even lower, down to - 60 degrees Celsius. A typical application where such low temperatures occur is for an active clamped circuit used onboard commercial aircraft in flight. Extensive test measurements carried out by the inventor, in order to improve response time of active clamped circuits under low temperatures revealed that replacing the zener diodes by other avalanche diodes, like TVS diodes, did not improve the response time significantly. However, these experiments indicated that the response time of the feedback path can be improved under low temperature conditions by connecting such capacitor C in parallel to the rectifier diode D.

As a result of the low temperatures experiments, it is assumed that the rectifier diode D for some reasons delays current flow in the feedback path once the avalanche diode (Zener diode or TVS diode) has connected through as a result of the voltage exceeding its avalanche breakdown potential.

Connecting capacitor C in parallel to the rectifier diode seems to allow current to flow instantaneously in the feedback path from the drain node 112 and through the at least one Zener diode Z1, ...,Zn when the drain to gate voltage of the transistor 110 exceeds the avalanche breakdown potential of the at least one Zener diode Z1, ..., Zn.

When the drain to gate voltage no longer exceeds the avalanche breakdown potential of the at least one Zener diode Z1, ..., Zn, the Zener diodes Z1, ..., Zn reset and return to a default state of blocking current flow in the feedback path.

It is noted that the feedback path from the drain to gate node does not have to take a high current as the active clamp transistor circuit 100 of Figure 2 utilizes the transistor 110 to absorb the majority of the clamp energy by means of a current flowing form the drain node 112 to the source node 114. Thus, the capacitor C connected parallel to the diode D needs to have just enough capacity to ensure that the active clamping response occurs immediately in reaction to the circuit first reaching the clamping voltage and that transient current flows up to 200ns afterwards, thereby avoiding significant voltage overshoot.

With respect to the second embodiment in Fig. 3, differently to Fig. 2, the conventional rectifier diode in the feedback path of the active clamped circuit 200 is replaced by a Schottky diode SD. The low temperature experiments carried out by the inventor also showed that replacing the rectifier diode D by a Schottky diode SD allows a similar improvement of the response time of the feedback path as is achieved by the capacitor C in the first embodiment. It is currently assumed that such effect is due to metal semiconductor junctions in Schottky diodes allowing a relatively high inherent capacity. Thus, the Schottky diode SD allows current to flow instantaneously in the feedback path from the drain node 112 and through the at least one Zener diode Z1, ..., Zn when the drain to gate voltage of the transistor 110 exceeds the avalanche breakdown potential of the at least one Zener diode Z1, ..., Zn.

Again, as discussed above, when the drain to gate voltage no longer exceeds the avalanche breakdown potential of the at least one Zener diode Z1, ..., Zn, the Zener diodes Z1, ..., Zn reset and return to a default state of blocking current flow in the feedback path.

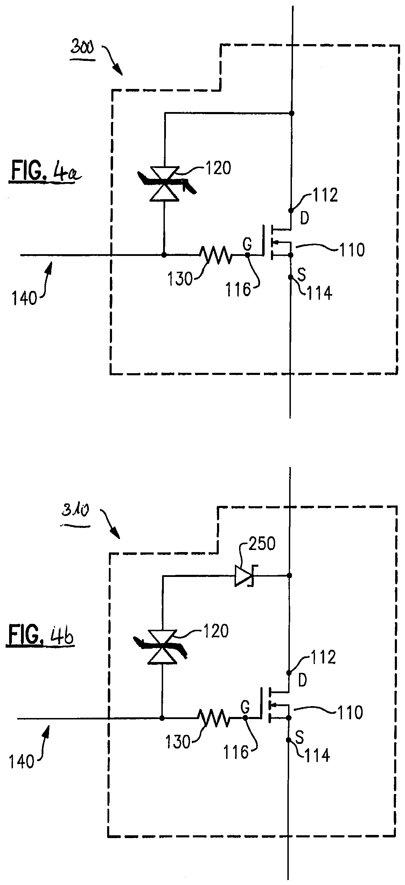

In the example shown in Figure 4a, a bi-directional TVS diode 120 connects the conditioning resistor 130 to the drain node 112 of the transistor 110. The bi-directional TVS diode 120 allows power to flow from the drain node 112 and through the bi-directional TVS diode 120 when the drain to gate voltage of the transistor 110 exceeds the avalanche breakdown potential of the bi-directional TVS diode 120. When the drain to gate voltage no longer exceeds the avalanche breakdown potential of the bi-directional TVS diode 120, the bi-directional TVS diode 120 resets and returns to the default state of blocking current flow.

Due to the drain to gate connection of the bi-directional TVS diode 120, the TVS diode basically is over engineered as it is typically sized to absorb more energy as required since here the active clamped transistor circuit 100 of Figure 4a utilizes the transistor 110 to absorb the majority of the clamp energy by means of a current flowing form the drain node 112 to the source node 114 once the gate electrode 116 is activated by the transient current in the feedback path.

The illustrated bi-directional TVS diode 120 allows current flow in either direction when the avalanche breakdown potential is exceeded. Additionally, the low temperature experiments described above also revealed that the bi-directional TVS diode 120 provides a significant switching speed benefit over unidirectional TVS diode/rectifier diode and Zener diode/rectifier diode circuits when the circuit is operating at low temperatures, e.g. at - 15 degrees Celsius or lower, or even at - 25 degrees Celsius or lower, or even at - 40 degrees Celsius or lower, down to - 60 degrees Celsius. This advantage is partially offset by a significantly higher cost of bidirectional TVS diodes relative to unidirectional TVS diode/rectifier diode or Zener diode/rectifier diode circuits.

The power flow across the bidirectional TVS diode 120 during an overvoltage provides a control signal to the gate node 116 through the conditioning resistor 130. In this way, the transistor 110 is turned on when the drain to gate voltage of the transistor 110 exceeds the avalanche breakdown potential of the bidirectional TVS diode 120. The bidirectional TVS diode 120 prevents current flow at all other times, effectively having no impact on the circuit when no overvoltage is present. Figure 4b illustrates a second version of the example, in which an active clamped transistor circuit 310 including the transistor 110 is shown. Additionally, the active clamped transistor circuit of Figure 4b includes a further Zener diode 250, connected between the bi-directional TVS diode 120 and the drain node 112. The Zener diode 250 is used to further adjust the breakdown voltage of the feedback path, i.e. to increase the brake down voltage already provided by the bi-directional TVS diode 120.

As a further result, the inventor has also found experimentally that the known active clamped circuit may be improved by merely substituting the conventional rectifier diode by a unidirectional TVS diode. In such embodiment the unidirectional TVS diode is used in the same way as a conventional rectifier diode, i.e is connected in flow direction with respect to current from the drain node 112 to the gate node 116. The TVS diode is not operated as an avalanche diode, in contrast to its usual use.

Basically, with active clamped circuits of the type describe herein, in a situation where the active clamp circuit, in particular the feedback path thereof, in a power switch has a slower response time than the switching rate of the transistor 110, at the start of an overvoltage the transistor 110 would temporarily enter an avalanche breakdown state. Entering the avalanche breakdown state occurs because the transistor 110 switches to the avalanche breakdown state faster than the active clamp circuit opens the transistor 110 via the feedback path to prevent the overvoltage when the transistor 110 switch speed is faster than the response time of the active clamp circuit. If the transistor 110 enters the avalanche breakdown state, the transistor 110 can be damaged or destroyed. Thus, the switching rate of the transistor 110 is effectively limited to greater than the response time of the active clamp circuit.

In all embodiments shown in Figs. 2 to 3 and described herein, it is ensured that the feedback path of the active clamped transistor circuit 100 and 200 responds faster than the transistor 110 can change into an avalanche breakdown condition, even at low temperatures. The feedback path will always activate the transistor 110 before the transistor 110 enters the avalanche breakdown state. The faster response time of the feedback path allows the active voltage clamping circuit of the invention to provide an active clamp for a state of the art power transistor 110, e.g. a bipolar junction transistor, BJT, or a metal oxide semiconductor field effect transistor, MOSFET, that has a fast switching speed.

The active clamped transistor circuits 200, 300, and 310 are also characterized by an absence of any rectifier diodes. The rectifier function of such diodes is provided by other components like Schottky diodes or TVS diodes connected in flow direction.

Figure 5 illustrates an aircraft 1, having an onboard power distribution system 2. The onboard power distribution system 2 includes a controller 3 capable of controlling the distribution of power through the aircraft to multiple different electronic components 4. Included in the controller 3 are multiple power switch circuits 32. While Fig. 5 illustrates four power switch circuits 32, a practical implementation of the power distribution system 2 would include significantly more power switch circuits 32.

The embodiments described above provide for an improved active clamped transistor circuit that is particularly reliable in low temperature conditions.

Each embodiment described herein improves the basically known active clamped transistor circuit comprising a transistor having a control node to control the conduction state of controlled current path between a first output node and a second output node, wherein in case of a voltage between the first and the second output nodes exceeding a threshold voltage, the transistor is turned on by means of a feedback path coupling the first output node to the control node such that current is allowed to flow across the controlled current path of the transistor to prevent excessive voltages between the first and the second output nodes. Basically, each embodiment described herein improves the response time of the feedback path, in particular in the active clamped circuit under low temperature conditions such as at - 15 degrees Celsius or lower, or even at - 25 degrees Celsius or lower, or even at - 40 degrees Celsius or lower, or even down to - 60 degrees Celsius.

Conventionally, the feedback path of the active clamped transistor circuit comprises a serial connection of at least one Zener diode and/or at least one unidirectional transient voltage suppressor (TVS) diode, connected in blocking direction, and at least one rectifier diode connected in flow direction, all directions with respect to the direction of current from the first output node to the control node of the transistor.

Based on extensive testing and investigations the inventor identified the conventional rectifier diode as inter alia one root cause for failing of some channels of an AC SSPC on an instantaneous trip test carried out under low temperatures.

According to a first embodiment, an improved active clamped circuit further comprises a capacitor connected parallel to the rectifier diode (D). The capacitor preferably has a capacitance of at least 27pF, most preferably at least 68pF. This is a practical solution as already existing circuit designs may be maintained since the improvement merely requires the additional capacitor elements connected in parallel to the respective conventional rectifier diodes.

According to a second embodiment, the feedback path of an improved active clamped transistor circuit includes a serial connection of at least one Zener diode and/or at least one unidirectional transient voltage suppressor diode, connected in blocking direction, and at least one Schottky diode connected in flow direction, all directions with respect to the direction of current from the first output node to the control node of the transistor. Using a Schottky diode instead of a conventional rectifier diode helps to suppress any overshoots in case of clamping after an instantaneous trip. This is a very practical solution as the overall components required for the circuit are not increased, whilst a small increase in costs.

In further developments, the active clamped transistor circuit of any embodiment further may comprise a conditioning resistor that is connected with one end to the control node of said transistor and with another end to an input node of the circuit. The feedback path and said conditioning resistor may be connected in series.

In the active clamped transistor circuit of any embodiment, said transistor may be a metal oxide semiconductor field effect transistor (MOSFET). Accordingly, the control node is a gate to control the conduction state of current path between a Drain as the first output node and a Source as the second output node. Alternatively, said transistor may be a bipolar junction transistor (BJT). Accordingly, the control node is a base to control the conduction state of current path between a collector as the first output node and an emitter as the second output node.

In the improved active clamped transistor circuit of any embodiment, a response time of said feedback path is achieved that is less than a switching time of said transistor, even at low temperature of - 15 degrees Celsius or lower, or even of - 25 degrees Celsius or lower, or even of - 40 degrees Celsius or lower, down to - 60 degrees Celsius. Particularly, the active clamping response occurs immediately at the time when the circuit first reaches the clamping voltage, and up to 200 ns afterwards, thereby avoiding significant voltage overshoot.

The active clamped transistor circuits of the embodiments described above are characterized by an absence of conventional rectifier diodes. As far as conventional rectifier diodes are still used, as in the first embodiment, their delayed response is compensated by connecting a capacitor in parallel.

A further embodiment comprises a power distribution system comprising at least one or a plurality of power distribution switches, wherein the at least one, or the plurality of, power distribution switches comprises an active clamped transistor circuit according to any of the embodiments described. Such power distribution system is especially configured for use in an onboard electronic system of aircraft flying at flight levels above 4.000 meter.

Active clamped circuits as described herein may be used in electronic devices which are subject to operating conditions in which a surrounding temperature is - 15 degrees Celsius or below, or even - 25 degrees Celsius or below, or even - 40 degrees Celsius or below, or even down to - 60 degrees Celsius.

Further embodiments described herein relate to a method for improving active clamped transistor circuits with respect to response time at low temperatures. Accordingly, the known active clamped transistor circuit may be improved by connecting a capacitor with a suitable capacitance in parallel to the conventional rectifier diode.

Alternatively, the feedback path of the known active clamped transistor circuit may be modified so that it comprises a serial connection of at least one Zener diode and/or at least one unidirectional transient voltage suppressor diode, connected in blocking direction, and, instead of the conventional rectifier diode, a Schottky diode connected in blocking direction, all directions with respect to the direction of current from the drain node to the gate node.

Basically, the low temperature experiments carried out by the inventor with regard to the root cause for failing of the conventional active clamped circuit showed that there is a combination of effects, which generates the overshoot problem at the transistor output. Due to a thermally lowered breakdown voltage of the transistor and the increasing delay time in the feedback path at low temperatures, with decreasing temperature overshoots become more likely. Thus, damages to the transistors become very likely.

As a result of the low temperature experiments, the inventor assumes that the increasing delay in the response time of the feedback path is mainly caused by the conventional rectifier diode, especially at low temperature operating conditions such as - 15 degrees Celsius or below, or even - 25 degrees Celsius or below, or even - 40 degrees Celsius or below, or even down to - 60 degrees Celsius.

Accordingly, the effect of the respective improvement made to the conventional active clamped circuit is expected to be caused by improved capability of the feedback path to draw current in the point of time when an overvoltage occurs between the output nodes of the transistor.

In the first embodiment described above, the capability to draw current of the conventional rectifier diode is improved by means of the capacitor having a suitable capacitance value which is connected in parallel to the rectifier diode.

By the second embodiment described above, the response time of the feedback path is improved by using the Schottky diode instead of the conventional rectifier diode. It is assumed that the positive effect caused by Schottky diode having a higher junction capacity as conventional rectifier diodes.

The low temperature effect becomes more expectable with lower temperatures, such as e.g. -15 degrees Celsius or below, or even -25 degrees Celsius or below, or even -40 degrees Celsius or below, or even down to -60 degrees Celsius. Such low temperatures may be expected for instance in onboard systems of aircrafts with flight levels of at least 4.000 meter and more.

Although the above active clamped circuit is described with regards to aircraft power distribution, it is understood that the disclosed circuit could be used in conjunction with any transistor switching circuit and still fall within the above disclosure.

## Claims

1. An active clamped transistor circuit (100) comprising:
a transistor (110) having a control node (116) to control the conduction state of a controlled current path between a first output node (112) and a second output node (114), wherein in case of a voltage between the first and the second output nodes (112, 114) exceeding a threshold voltage, the transistor (110) is turned on by means of a feedback path coupling the first output node (112) to the control node (116) such that current is allowed to flow across the controlled current path of the transistor (110) to prevent excessive voltages between the first and the second output nodes (112, 114),
the feedback path comprising a serial connection of: (i) at least one Zener diode (Z1, Zn) and/or at least one unidirectional transient voltage suppressor (TVS) diode, connected in blocking direction, and (ii) at least one rectifier diode (D) connected in flow direction, all directions with respect to the direction of current from the first output node (112) to the control node (116),
**characterized by**
a capacitor (C) connected parallel to the at least one rectifier diode (D).

2. The active clamped transistor circuit (100) of claim 1, wherein the capacitor (C) has a capacitance of at least 27pF, preferably at least 68pF.

3. An active clamped transistor circuit (200) comprising:
a transistor (110) having a control node (116) to control the conduction state of a controlled current path between a first output node (112) and a second output node (114), wherein in case of a voltage between the first and the second output nodes (112, 114) exceeding a threshold voltage, the transistor (110) is turned on by means of a feedback path coupling the first output node (112) to the control node (116) such that current is allowed to flow across the controlled current path of the transistor (110) to prevent excessive voltages between the first and the second output nodes (112, 114),
**characterized in that** the feedback path comprises a serial connection of:
(i) at least one Zener diode (Z1, Zn) and/or at least one unidirectional transient voltage suppressor (TVS) diode, connected in blocking direction, and
(ii) at least one Schottky diode (SD) connected in flow direction, all directions with respect to the direction of current from the first output node (112) to the control node (116).

4. The active clamped transistor circuit of any of the preceding claims, further comprising a conditioning resistor (130) connected with one end to the control node (116) of said transistor (110) and with another end to an input node (140) of the circuit (100; 200); said feedback path and said conditioning resistor (130) being connected in series.

5. The active clamped transistor circuit (100; 200) of any of the preceding claims,
wherein said transistor (110) is a metal oxide semiconductor field effect transistor (MOSFET) and the control node (116) is a gate (G) to control the conduction state of current path between a Drain (D) as the first output node (112) and a Source (S) as the second output node (114), or
wherein said transistor (110) is a bipolar junction transistor (BJT) and the control node (116) is a base to control the conduction state of current path between a collector as the first output node and a emitter as the second output node.

6. The active clamped transistor circuit (100; 200) of any of the preceding claims, wherein a response time of said feedback path is less than a switching time of said transistor (110) at temperatures of - 15 degrees Celsius or lower, at temperatures of - 25 degrees Celsius or lower, at temperatures of - 40 degrees Celsius or lower, at temperatures down to - 60 degrees Celsius, so that the active clamping response occurs in the time when the circuit first reaches the clamping voltage, and within 200ns afterwards, thereby avoiding significant voltage overshoot.

7. The active clamped transistor circuit (200) of any of claims 3 to 6, as far as dependent on claim 3, wherein the active clamped transistor circuit does not contain rectifier diodes.

8. A power distribution system comprising:
at least one power distribution switch having an active clamped transistor circuit according to any of the preceding claims.

9. The power distribution system of claim 8 configured to be suitable for use in an onboard electronic system of aircraft for flight levels above 4.000 meters.

10. Use of an electronic device comprising the active clamped transistor circuit (100; 200) of any of claims 1 to 8 under operating conditions in which a surrounding temperature is - 15 degrees Celsius or below; - 25 degrees Celsius or below; - 40 degrees Celsius or below, down to - 60 °C.

11. A method for clamping a transistor by means of an active clamped transistor circuit **characterized in that** the means for clamping the transistor is the active clamped transistor circuit according to any of claims 1 to 8.

## Patentansprüche

1. Aktive geklemmte Transistorschaltung (100), umfassend:
einen Transistor (110) mit einem Steuerknoten (116) zum Steuern des Leitungszustands eines gesteuerten Strompfads zwischen einem ersten Ausgangsknoten (112) und einem zweiten Ausgangsknoten (114), wobei für den Fall, dass eine Spannung zwischen dem ersten und dem zweiten Ausgangsknoten (112, 114) eine Schwellenspannung überschreitet, der Transistor (110) mit einem Rückkopplungspfad, der den ersten Ausgangsknoten (112) an den Steuerknoten (116) koppelt, eingeschaltet wird, sodass Strom über den gesteuerten Strompfad des Transistors (110) fließen kann, um übermäßige Spannungen zwischen dem ersten und dem zweiten Ausgangsknoten (112, 114) zu verhindern, wobei der Rückkopplungspfad eine serielle Verbindung von Folgenden umfasst: (i) mindestens einer Zener-Diode (Z1, Zn) und/oder mindestens einer unidirektionalen transienten Spannungssuppressor-(TVS-)diode, die in Sperrrichtung verbunden ist, und (ii) mindestens einer Gleichrichterdiode (D), die in Fließrichtung verbunden ist, wobei alle Richtungen in Bezug auf die Richtung des Stroms vom ersten Ausgangsknoten (112) zum Steuerknoten (116) erfolgen,
**gekennzeichnet durch**
einen Kondensator (C), der parallel zu der mindestens einen Gleichrichterdiode (D) verbunden ist.

2. Aktive geklemmte Transistorschaltung (100) nach Anspruch 1, wobei der Kondensator (C) eine Kapazität von mindestens 27 pF, vorzugsweise mindestens 68 pF aufweist.

3. Aktive geklemmte Transistorschaltung (200), umfassend:
einen Transistor (110) mit einem Steuerknoten (116) zum Steuern des Leitungszustands eines gesteuerten Strompfads zwischen einem ersten Ausgangsknoten (112) und einem zweiten Ausgangsknoten (114), wobei für den Fall, dass eine Spannung zwischen dem ersten und dem zweiten Ausgangsknoten (112, 114) eine Schwellenspannung überschreitet, der Transistor (110) mit einem Rückkopplungspfad, der den ersten Ausgangsknoten (112) an den Steuerknoten (116) koppelt, eingeschaltet wird, sodass Strom über den gesteuerten Strompfad des Transistors (110) fließen kann, um übermäßige Spannungen zwischen dem ersten und dem zweiten Ausgangsknoten (112, 114) zu verhindern,
**dadurch gekennzeichnet, dass** der Rückkopplungspfad eine serielle Verbindung von Folgenden umfasst: (i) mindestens einer Zener-Diode (Z1, Zn) und/oder mindestens einer unidirektionalen transienten Spannungssuppressor-(TVS-)diode, die in Sperrrichtung verbunden ist, und (ii) einer Schottky-Diode (SD), die in Fließrichtung verbunden ist, wobei alle Richtungen in Bezug auf die Richtung des Stroms vom ersten Ausgangsknoten (112) zum Steuerknoten (116) erfolgen.

4. Aktive geklemmte Transistorschaltung nach einem der vorhergehenden Ansprüche, ferner umfassend einen Konditionierungswiderstand (130), der mit einem Ende mit dem Steuerknoten (116) des Transistors (110) und mit dem anderen Ende mit einem Eingangsknoten (140) der Schaltung (100; 200) verbunden ist;
wobei der Rückkopplungspfad und der Konditionierungswiderstand (130) in Reihe verbunden sind.

5. Aktive geklemmte Transistorschaltung (100; 200) nach einem der vorhergehenden Ansprüche, wobei der Transistor (110) ein Metall-Oxid-Halbleiter-Feldeffekttransistor (MOSFET) ist und der Steuerknoten (116) ein Gate (G) zum Steuern des Leitungszustands des Strompfads zwischen einem Ablauf (D) als der erste Ausgangsknoten (112) und einer Quelle (S) als der zweite Ausgangsknoten (114) ist, oder
wobei der Transistor (110) ein Bipolartransistor (BJT) ist und der Steuerknoten (116) eine Basis zum Steuern des Leitungszustands des Strompfads zwischen einem Kollektor als der erste Ausgangsknoten und einem Emitter als der zweite Ausgangsknoten ist.

6. Aktive geklemmte Transistorschaltung (100; 200) nach einem der vorhergehenden Ansprüche, wobei eine Reaktionszeit des Rückkopplungspfads kürzer ist als eine Schaltzeit des Transistors (110) bei Temperaturen von -15 Grad Celsius oder niedriger, bei Temperaturen von -25 Grad Celsius oder niedriger, bei Temperaturen von -40 Grad Celsius oder niedriger, bei Temperaturen bis zu -60 Grad Celsius, sodass die aktive Klemmreaktion in der Zeit erfolgt, in der die Schaltung zuerst die Klemmspannung erreicht, und innerhalb von 200 ns danach, wodurch eine signifikante Spannungsüberhöhung vermieden wird.

7. Aktive geklemmte Transistorschaltung (200) nach einem der Ansprüche 3 bis 6, soweit sich diese auf Anspruch 3 beziehen, wobei die aktive geklemmte Transistorschaltung keine Gleichrichterdioden enthält.

8. Leistungsverteilungssystem, umfassend:
mindestens einen Leistungsverteilungsschalter mit einer aktiven geklemmten Transistorschaltung nach einem der vorhergehenden Ansprüche.

9. Leistungsverteilungssystem nach Anspruch 8, das dazu konfiguriert ist, zur Verwendung in einem bordeigenen elektronischen System eines Luftfahrzeugs für Flughöhen über 4.000 Meter geeignet zu sein.

10. Verwendung einer elektronischen Vorrichtung, umfassend die aktive geklemmte Transistorschaltung (100; 200) nach einem der Ansprüche 1 bis 8, unter Betriebsbedingungen, bei denen eine Umgebungstemperatur -15 Grad Celsius oder niedriger; -25 Grad Celsius oder niedriger; -40 Grad Celsius oder niedriger; bis zu -60 °C beträgt.

11. Verfahren zum Klemmen eines Transistors mittels einer aktiven geklemmten Transistorschaltung, **dadurch gekennzeichnet, dass** das Mittel zum Klemmen des Transistors die aktive geklemmte Transistorschaltung nach einem der Ansprüche 1 bis 8 ist.

## Revendications

1. Circuit de transistor avec calage actif (100) comprenant :
un transistor (110) ayant un noeud de commande (116) pour commander l'état de conduction d'un trajet de courant commandé entre un premier noeud de sortie (112) et un second noeud de sortie (114),
dans lequel, dans le cas d'une tension entre les premier et second noeuds de sortie (112, 114) dépassant une tension de seuil, le transistor (110) est activé au moyen d'un trajet de rétroaction couplant le premier noeud de sortie (112) au noeud de commande (116) de sorte que le courant est autorisé à passer sur le trajet de courant commandé du transistor (110) pour empêcher des tensions excessives entre les premier et second noeuds de sortie (112, 114), le trajet de rétroaction comprenant une connexion en série : (i) d'au moins une diode Zener (Z1, Zn) et/ou d'au moins une diode de suppression de tension transitoire unidirectionnelle (TVS), connectée dans le sens de blocage, et (ii) d'au moins une diode de redressement (D) connectée dans le sens du flux, tous les sens par rapport au sens du courant du premier noeud de sortie (112) au noeud de commande (116),
**caractérisé par**
un condensateur (C) connecté en parallèle à l'au moins une diode de redressement (D).

2. Circuit de transistor avec calage actif (100) selon la revendication 1, dans lequel le condensateur (C) a une capacité d'au moins 27pF, de préférence d'au moins 68pF.

3. Circuit de transistor avec calage actif (200) comprenant :
un transistor (110) ayant un noeud de commande (116) pour commander l'état de conduction d'un trajet de courant commandé entre un premier noeud de sortie (112) et un second noeud de sortie (114), dans lequel, dans le cas d'une tension entre les premier et second noeuds de sortie (112, 114) dépassant une tension de seuil, le transistor (110) est activé au moyen d'un trajet de rétroaction couplant le premier noeud de sortie (112) au noeud de commande (116) de sorte que le courant est autorisé à passer sur le trajet de courant commandé du transistor (110) pour empêcher des tensions excessives entre les premier et second noeuds de sortie (112, 114),
**caractérisé en ce que** le trajet de rétroaction comprend une connexion en série :
(i)d'au moins une diode Zener (Z1, Zn) et/ou d'au moins une diode de suppression de tension transitoire unidirectionnelle (TVS), connectée dans le sens du blocage, et
(ii)d'au moins une diode Schottky (SD) connectée dans le sens du flux, tous les sens par rapport au sens du courant du premier noeud de sortie (112) au noeud de commande (116).

4. Circuit de transistor avec calage actif selon l'une quelconque des revendications précédentes, comprenant en outre une résistance de conditionnement (130) connectée, par une extrémité, au noeud de commande (116) dudit transistor et, par une autre extrémité, à un noeud d'entrée (140) du circuit (100 ; 200) ; ledit trajet de rétroaction et ladite résistance de conditionnement (130) étant connectés en série.

5. Circuit de transistor avec calage actif (100 ; 200) selon l'une quelconque des revendications précédentes,
dans lequel ledit transistor (110) est un transistor à effet de champ à semi-conducteur à oxyde métallique (MOSFET) et le noeud de commande (116) est une grille (G) destinée à commander l'état de conduction du trajet de courant entre un drain (D) en tant que premier noeud de sortie (112) et une source (S) en tant que second noeud de sortie (114), ou
dans lequel ledit transistor (110) est un transistor à jonction bipolaire (BJT) et le noeud de commande (116) est une base pour commander l'état de conduction du trajet de courant entre un collecteur en tant que premier noeud de sortie et un émetteur en tant que second noeud de sortie.

6. Circuit de transistor avec calage actif (100 ; 200) selon l'une quelconque des revendications précédentes, dans lequel un temps de réponse dudit trajet de rétroaction est inférieur à un temps de commutation dudit transistor (110) à des températures inférieures ou égales à -15 degrés Celsius, à des températures inférieures ou égales à -25 degrés Celsius, à des températures inférieures ou égales à -40 degrés Celsius, à des températures pouvant descendre jusqu'à -60 degrés Celsius, de sorte que la réponse de calage actif se produit au moment où le circuit atteint d'abord la tension de calage, et dans les 200ns ensuite, évitant ainsi un dépassement important de tension.

7. Circuit de transistor avec calage actif (200) selon l'une quelconque des revendications 3 à 6, lorsqu'il dépend de la revendication 3, dans lequel le circuit de transistor avec calage actif ne contient pas de diodes de redressement.

8. Système de distribution d'énergie comprenant :
au moins un commutateur de distribution d'énergie comportant un circuit de transistor avec calage actif selon l'une quelconque des revendications précédentes.

9. Système de distribution d'énergie selon la revendication 8, configuré pour pouvoir être utilisé dans un système électronique embarqué d'un aéronef pour des niveaux de vol supérieurs à 4 000 mètres.

10. Utilisation d'un dispositif électronique comprenant le circuit de transistor avec calage actif (100 ; 200) selon l'une quelconque des revendications 1 à 8 dans des conditions de fonctionnement dans lesquelles une température ambiante est inférieure ou égale à -15 degrés Celsius ; inférieure ou égale à -25 degrés Celsius ; inférieure ou égale à -40 degrés Celsius, et peut descendre jusqu'à -60 °C.

11. Procédé de calage d'un transistor au moyen d'un circuit de transistor avec calage actif, **caractérisé en ce que** le moyen de calage du transistor est le circuit de transistor avec calage actif selon l'une quelconque des revendications 1 à 8
